# EUROPEAN PATENT SPECIFICATION

(11) **EP 1 876 497 B1**
(45) Date of publication and mention of the grant of the patent: **25.07.2012**
(21) Application number: 06732408.7
(22) Date of filing: 27.04.2006
(51) Int. Cl.: G03G 9/12, G03G 9/125, G03G 9/135, G03G 9/13

(54) **LIQUID DEVELOPER**
FLÜSSIGER ENTWICKLER
REVELATEUR LIQUIDE

(30) Priority: 28.04.2005 JP 2005132775
(43) Date of publication of application: 09.01.2008
(73) Proprietor: SAKATA INX CORPORATION, Osaka-shi, Osaka 550-0002 (JP)
(72) Inventor: IWASE, Koji, c/o SAKATA INX CORP., Osaka-shi, Osaka 550-0002 (JP); MAEDA, Hirohito, c/o SAKATA INX CORP., Osaka-shi, Osaka 550-0002 (JP); YODO, Takaaki, c/o SAKATA INX CORP., Osaka-shi, Osaka 550-0002 (JP); SHIBATA, Hideo, c/o SAKATA INX CORP., Osaka-shi, Osaka 550-0002 (JP)
(74) Representative: Hart-Davis, Jason
(86) International application number: PCT/JP2006/308852
(87) International publication number: WO 2006/118201

(56) References cited:
- EP-A1- 1 493 783
- EP-A1- 1 535 971
- WO-A1-2004/000950
- JP-A- 04 073 664
- JP-A- 08 220 812
- JP-A- 2004 083 872

## Description

### TECHNICAL FIELD

The present invention relates to a liquid developer for electrophotography or electrostatic recording used in printing machines, copiers, printers and facsimiles.

### BACKGROUND ART

The liquid developer is generally formed by dispersing colored resin particles (toner particles) encapsulating a colorant such as a pigment in a highly insulating organic medium. In an electrophotography method or an electrostatic recording method using this liquid developer, development is performed by use of phenomenon in which the toner particle electrically migrate in the organic medium by applying an electric field. In practice, the developer is reserved on or applied to one side of the opposed electrodes, and an electric field corresponding to an electric latent image is applied between the electrodes, and thereby only toner particles on which the forces of the electric field are exerted migrate selectively and adheres to an image area to achieve development.

Today, it is desired that a developing speed is faster and obtained images are finer, and primarily, a colorant has to be dispersed well in a resin constituting the toner particle, and further, the toner particle has to be dispersed well in an organic medium. If the dispersibility is excellent in both the colorant and the toner particle, speedups of developing and improvements in image qualities are expected through an improvement in a coloring power, a reduction in developer's viscosity, and an improvement in mobility of the toner particle.

Pigments are currently used in most cases as a colorant, and improvements in the dispersibility of the pigment or the toner particle in the liquid developer have been tried in order to realize the above desires. For example, as a method of improving the dispersibility of toner particles having a large effect particularly on developing performance, a method of using poly(hydroxycarboxylic ester) or a material having a polar group such as a base or the like at its end (for example, refer to Patent Document 1) is disclosed. However, this method has a problem that the dispersibility cannot be improved well by simple poly(hydroxycarboxylic ester, and in the case of the material having a polar group such as a base or the like at its end, this brings the reduction in the insulating property of an organic medium or the deterioration of the electrically charged characteristics of a toner resulting from the polar group component and good image quality cannot be attained.

Furthermore, when a composite material of a pigment and a resin is powdered by a wet-grinding method, the composite material is often ground at an interface between the pigment and the resin, and it becomes a state of exposing the pigment at the surfaces of the resulting toner particles. It is known that since the electrically charged characteristics of the pigments varies from color to color, the control of charging is required for every color, and it is more difficult to attain good image quality in the toner particles obtained by the wet-grinding method.
Thus, it is still the case that a method of using particularly the toner particles obtained by the wet-grinding method to achieve a balance between maintaining of an insulating property and an electrically charged characteristic, and the dispersibility of the pigment and the toner particle, which can be applied to any color of colorant, is not yet found.
Patent Document 1: Japanese Kokai Publication No. Hei-5-273792

### SUMMARY OF THE INVENTION

The present invention provides a liquid developer in which, in liquid developers for electrophotography or electrostatic recording, the adverse effect on electric resistance of the liquid developer and the electrically charged characteristics of toner particles is minimized and the dispersibility of a pigment and the dispersion stability of the toner particles are improved.

The present inventors made earnest investigations in order to solve the above-mentioned problem, and consequently found that by using a specific dispersant for a liquid developer, the liquid developer can be applied to a liquid developers without particularly depending on the species of a pigment, and it is possible to minimize the adverse effect on the electric resistance of the liquid developer and the electrically charged characteristics of toner particles and to improve the dispersibility of a pigment and the dispersion stability of the toner particles. These findings have now led to completion of the present invention.
That is, the present invention relates to (1) a liquid developer, which is obtained by dispersing colored resin particles encapsulating a pigment in an insulating hydrocarbon organic solvent by a wet-grinding method using a dispersant, wherein the dispersant is a polyester side chain-containing carbodiimide type compound formed by introducing a polyester side chain into a molecule of a carbodiimide compound through a reaction with a carbodiimide group.
The present invention relates to (2) the liquid developer according to the aspect (1), wherein a polyester side chain-containing carbodiimide type compound with a carbodiimide equivalent weight of 100 to 50000 is used as the dispersant.
The present invention relates to (3) the liquid developer according to the aspect (1) or (2), wherein a polyester side chain-containing carbodiimide type compound having a basic nitrogen-containing group is used as the dispersant.
Further, the present invention relates to (4) the liquid developer according to the aspect (3), wherein a polyester side chain-containing carbodiimide type compound having a basic nitrogen-containing group on the main chain of the carbodiimide type compound is used as the dispersant.
Further, the present invention relates to (5) the liquid developer according to the aspect (3) or (4), wherein the basic nitrogen-containing group is a tertiary amino group.
The present invention relates to (6) the liquid developer according to any one of the aspects (1) to (5), wherein a polyester side chain-containing carbodiimide type compound in which a number average molecular weight of the polyester side chain is 200 to 10000 is used as the dispersant.
The present invention relates to (7) the liquid developer according to any one of the aspects (1) to (6), wherein a polyester side chain-containing carbodiimide type compound into which a polyester side chain resulting from self polycondensate of hydroxycarboxylic acid is introduced is used as the dispersant.
The present invention relates to (8) the liquid developer according to any one of the aspects (1) to (7), wherein a polyester side chain-containing carbodiimide type compound into which a polyester side chain resulting from self polycondensate of 12-hydroxystearic acid is introduced is used as the dispersant.
Further, the present invention relates to (9) the liquid developer according to any one of the aspects (1) to (8), wherein a paraffinic solvent having a high boiling point is used as the insulating hydrocarbon organic solvent.

### DETAILED DESCRIPTION OF THE INVENTION

Hereinafter, the liquid developer of the present invention will be described in detail.
Examples of the pigment used in the present invention include inorganic pigments and organic pigments, and specific examples of them include inorganic pigments such as acetylene black, graphite, red oxide, chrome yellow, ultramarine blue pigment, carbon black, and organic pigments such as azo pigment, lake pigment, phthalocyanine pigment, isoindoline pigment, anthraquinone pigment, quinacridone pigment.

The pigment is preferably a pigment having a site adsorbing to the basic nitrogen-containing group when a carbodiimide type compound described later has the basic nitrogen-containing group, and the site adsorbing to a basic nitrogen-containing group is typically an acid group, and preferably a functional group capable of reacting with the basic nitrogen-containing groups such as a carboxyl group, a sulfonic acid group. Further, even in the pigment which is not yet treated and does not have a site adsorbing to the basic nitrogen-containing group, the carboxyl group or the sulfonic acid group can be treated by a normal method of introducing a functional group such as a derivative treatment or a sulfonation treatment of the surface of a pigment as an introduction method of the carboxyl group or the sulfonic acid group to be used.

The pigment is preferably a pigment further having a functional group capable of reacting with the carbodiimide group when a carbodiimide type compound described later has the carbodiimide group. Herein, as the functional group capable of reacting with the carbodiimide group, at least one functional group selected from the group consisting of a carboxyl group, a hydroxyl group, a phosphoric acid group and an amino group is preferable. Even in the pigment not having the functional group capable of reacting with the carbodiimide group, the functional group can be introduced by a surface treatment, and for example, the functional group capable of reacting with the above carbodiimide group can be introduced by a plasma treatment or a oxygen/ultraviolet light treatment described in "Techniques and Evaluations of Pigment Dispersion Stabilization and Surface Treatment" (1st edition, TECHNICAL INFORMATION INSTITUTE CO., LTD., December 25 (2001), p.76-85), or a low temperature plasma process described in Japanese Kokai Publication No. Sho-58-217559 besides the above-mentioned derivative treatment or sulfonation treatment.
In the present invention, the content of the pigment is not particularly limited, but from the viewpoint of an image density, the pigment content is preferably 2 to 20 % by mass in the ultimate liquid developer.

Next, as a resin used for forming colored resin particles encapsulating a pigment to become toner particles in the present invention, a thermoplastic resin having a fixing property to an adherend such as paper for printing is preferable, and specific examples of the resin include a resin formed by modifying an polyolefin resin and introducing a carboxyl group, olefin resins such as an ethylene- (meth) acrylic acid copolymer, an ethylene-vinyl acetate copolymer, a partially saponified product of an ethylene-vinyl acetate copolymer, an ethylene- (meth) acrylate copolymer, a polyethylene resin and a polypropylene resin; a thermoplastic saturated polyester resin, styrenic resins such as a styrene-acrylic copolymer resin and a styrene-acryl modified polyester resin; an alkyd resin, a phenolic resin, an epoxy resin, a rosin modified phenolic resin, a rosin modified maleic acid resin, a rosin modified fumaric acid resin, acrylic resins such as an (meth)acrylate resin; a vinyl chloride resin, a vinyl acetate resin, a vinylidene chloride resin, fluororesins, polyamide resins, and a polyacetal resin. These resins may be used singly or in combination of two or more species.
In addition, the total content of the pigment and the resin in the liquid developer of the present invention is preferably 10 to 50% by mass, and more preferably 15 to 40 % by mass. When this content is less than 10% by mass, a liquid developer of sufficient concentrations may not be obtained, and when it is more than 50% by mass, a problem that the viscosity of the liquid developer becomes too high may arise.

The colored resin particles encapsulating a pigment may be one in which at least a part of the surface of a pigment is coated with the resin and one resin particle includes one pigment piece or a plurality of pigment pieces.

Next, as an insulating hydrocarbon organic solvent used for the liquid developer of the present invention, solvents having resistivity (about 10¹¹ to 10¹⁶ Ω·cm) of such a level that electrostatic images are not disturbed are used. Examples of them include aliphatic hydrocarbon, alicyclic hydrocarbon, aromatic hydrocarbon, and halogenated hydrocarbon. Among others, paraffinic solvents having a high boiling point (boiling point of 150°C or higher) such as a normal paraffinic solvent, an isoparaffinic solvent, a cycloparaffinic solvent and a mixture thereof are preferable from the viewpoint of odor, harmlessness and cost. As commercially available solvents of paraffinic solvents having a high boiling point such as a normal paraffinic solvent, an isoparaffinic solvent, a cycloparaffinic solvent and a mixture thereof, for example, Isoper G, Isoper H, Isoper L and Isoper M, Exxsol D130 and Exxsol D140 (every produced by Exxon Chemical K.K.), Shellsol 71 (produced by Shell Chemicals), IP Solvent 1620, IP Solvent 2080 and IP Solvent 2835 (every Idemitsu Petrochemical Co., Ltd.), MORESCO WHITE P-40, MORESCO WHITE P-55 and MORESCO WHITE P-80 (every produced by MATSUMURA OIL RESEARCH Corp.), and liquid paraffin No. 40-S and liquid paraffin No.55-S (every produced by Chuokasei Co., Ltd.) are preferable.
In addition, the content of the insulating hydrocarbon organic solvent in the liquid developer of the present invention is preferably 50 to 90% by mass.

Next, examples of the dispersant used in the present invention include a polyester side chain-containing carbodiimide type compound formed by introducing a polyester side chain into a molecule of the carbodiimide compound through a reaction with a carbodiimide group.
Incidentally, in the present invention, a chain in a state of being branched from a carbodiimide compound-derived portion, which is formed by reacting the carbodiimide group of the carbodiimide compound with a compound having a group to react with the carbodiimide group, is referred to as a "side chain". In the present invention, the carbodiimide compound-derived portion is referred to as a "main chain" and all chains in a state of being branched from the main chain are referred to as a "side chain" regardless of the size of a chain structure.
The carbodiimide type compound of the present invention may be a compound in which all carbodiimide groups have been reacted with another functional group in order to introduce a polyester side chain, or may be a compound having unreacted carbodiimide groups, but the compound having unreacted carbodiimide groups is preferred.

### 1) Material for synthesizing a carbodiimide type compound

First, a carbodiimide compound, and a compound for introducing a polyester side chain being starting materials will be described as an essential constituent material of the carbodiimide type compound of the present invention.

### 1-1) Carbodiimide compound

The carbodiimide compound used as a starting material in order to obtain the carbodiimide type compound of the present invention has at least a carbodiimide group, namely, a group expressed by the formula -N=C=N- in a molecule, and such a carbodiimide compound will be described in more detail by exemplification of the preferred forms of the following paragraphs (a) to (d). The above-mentioned carbodiimide compound is appropriately selected according to the form of the compound to be used.

### (a) Carbodiimide compound having an isocyanate group, which is obtained by a decarboxylation reaction of a diisocyanate compound

The carbodiimide compound can be generally produced by converting the diisocyanate compound to carbodiimide by a decarboxylation reaction in the presence of a carbodiimide formation catalyst in an organic solvent, and further a carbodiimide compound having isocyanate groups on both ends of a molecule is obtained when its material is a diisocyanate compound.

In the above-mentioned production method, examples of the diisocyanate compound, which is subjected to a decarboxylation reaction, include aliphatic, alicyclic, aromatic or aroma-aliphatic diisocyanate compounds such as hexamethylene diisocyanate, isophorone diisocyanate, trilene diisocyanate, diphenylmethane diisocyanate, cyclohexane diisocyanate, dicyclohexylmethane diisocyanate, xylylene diisocyanate, tetramethylene diisocyanate and tetramethylxylylene diisocyanate.

As the above-mentioned organic solvent, a solvent having a high boiling point and not having an active hydrogen which reacts with an isocyanate compound and a produced carbodiimide compound is preferably used, and examples of the solvents include aromatic hydrocarbons such as toluene, xylene and diethyl benzene; glycol ether esters such as diethylene glycol diacetate, dipropylene glycol dibutylate, hexylene glycol diacetate, glycol diacetate, methyl glycol acetate, ethyl glycol acetate, butyl glycol acetate, ethyl diglycol acetate and butyl diglycol acetate; ketones such as ethyl butyl ketone, acetophenone, propiophenone, diisobutyl ketone and cyclohexanone; and aliphatic esters such as amyl acetate, propyl propionate and ethyl acetate.

As the above-mentioned carbodiimide formation catalyst, phospholenes or phospholene oxides are preferably used, and examples of them include 1-ethyl-3-methyl-3-phospholene oxide, 1-phenyl-3-methyl-3-phospholene oxide, and 1-phenyl-3-methyl-2-phospholene oxide.

As a method of performing a decarboxylation reaction of an isocyanate group using these materials, known methods can be employed, and this reaction can be performed, for example, at a reaction temperature of 100 to 200°C in a nitrogen atmosphere. Incidentally, examples of other methods of obtaining the compound having the carbodiimide group include the methods of U.S. patent No.2941956 specification, Japanese Kokai Publication No. Sho-47-33279, Japanese Kokai Publication No. Hei-5-178954, and Japanese Kokai Publication No. Hei-6-56950.

With respect to a carbodiimide compound having an isocyanate group, which is obtained by using such the production methods, for example, a compound which is obtained by decarboxylating k moles (k is an integer of 2 or more) of a diisocyanate compound is expressed by the following formula (1) :

OCN- (A-N=C=N)ₖ₋₁-A-NCO (1)

wherein A represents a residue which is the rest after eliminating an isocyanate group from the diisocyanate compound used for synthesis of a carbodiimide compound having an isocyanate group.

Examples of commercially available products of a carbodiimide compound having an isocyanate group, expressed by the formula (1), include CARBODILITE V-03 and V-05 (all trade name, produced by NISSHINBO INDUSTRIES, INC) as a carbodiimide compound made from tetramethylxylylene diisocyanate.

### (b) Carbodiimide compound obtained by further chain-extending the carbodiimide compound described in the paragraph (a) with a chain extender.

The carbodiimide compound is formed by increasing a molecular weight of the carbodiimide compound of the above paragraph (a) using a chain extender capable of reacting with an isocyanate group and it can be converted to a compound containing more carbodiimide groups in a molecule. As a chain extender which can be used in this case, a compound having low reactivity with a carbodiimide group and selectively reacting with an isocyanate group first is preferable, and examples of the compound include diol compounds such as 2,4-diethyl-1,5-pentanediol, a diamine compound, and hydrazine.

### (c) Compound obtained by decarboxylating 2 moles of a monoisocyanate compound and q moles (provided that q ≥ 1) of a diisocyanate compound

The carbodiimide compounds in the above paragraphs (a), (b) are a compound having the isocyanate groups at both ends of a molecule, and have advantages that various molecular chains can be added by use of the isocyanate group, but it has a problem that when a material to be reacted with the carbodiimide group also reacts with the isocyanate group, it is difficult to introduce this material as a side chain. On the other hand, in the carbodiimide compound in which a reaction of both ends of a molecule is terminated with a monoisocyanate compound, the above problem does not arise. Such the carbodiimide compound in which a reaction of both ends of a molecule is terminated with a monoisocyanate compound can be expressed by the following formula (2):

B-N=C=N-(A-N=C=N)_{q}-B (2)

wherein B represents a residue which is the rest after eliminating an isocyanate group from the monoisocyanate compound used for synthesis of a carbodiimide compound having an isocyanate group. A is as described above.

Examples of the diisocyanate compound which can be used here include the same compounds as those of synthetic materials in the above paragraph (a). Examples of the monoisocyanate compound include aliphatic, alicyclic, aromatic or aroma-aliphatic monoisocyanate compounds such as methyl isocyanate, ethyl isocyanate, propyl isocyanate, butyl isocyanate, octadecyl isocyanate and phenyl isocyanate.

### (d) Compound obtained by decarboxylating 1 mole of a monoisocyanate compound and r moles (provided that r ≥ 1) of a diisocyanate compound

As an intermediate compound between a carbodiimide compound having isocyanate groups at both ends of a molecule and a carbodiimide compound not having an isocyanate group at both ends of a molecule, a carbodiimide compound, in which a reaction of just one end is terminated with a monoisocyanate compound and a monoisocyanate group is positioned at the other end, can also be obtained. Such the carbodiimide compound in which a reaction of one end of a molecule is terminated with an isocyanate compound can be expressed by the following formula (3) :

OCN-(A-N=C-N)ᵣ-B (3)

wherein B represents a residue which is the rest after eliminating an isocyanate group from the monoisocyanate compound used for synthesis of a carbodiimide compound having an isocyanate group. A is as described above.

Examples of the diisocyanate compound which can be used here include the same compounds as those of synthetic materials in the above paragraph (a), and examples of the monoisocyanate compound include the same compounds as those of synthetic materials in the above paragraph (c).
The carbodiimide compounds (a) to (d) may be used singly or in combination of two or more species as a starting material of the carbodiimide compound.

### 1-2) Material for introducing a polyester side chain

Next, a compound used for introducing a polyester side chain into the carbodiimide compound will be described.
The carbodiimide type compound of the present invention is characterized by being prepared by use of a method of introducing a side chain by a reaction of the carbodiimide group with a functional group to react with the carbodiimide group and this side chain is a polyester side chain. Therefore, as the compound introduced as a side chain, polyester compounds having the functional group to react with the carbodiimide group and the polyester chain can be used.
Examples of the functional group to react with the carbodiimide group include a carboxyl group, a sulfonic acid group, a phosphoric acid group, a hydroxyl group and an amino group, and this functional group is preferably acid groups such as the carboxyl group, the sulfonic acid group, or the phosphoric acid group.

First, examples of the polyester compound include
(1) ring-opening polymerization compounds of a cyclic ester compound using oxycarboxylic acid, monoalcohol or a low molecular weight diol compound as an initiator (for example, polyester compounds containing a carboxyl group and a hydroxyl group, which are obtained by polymerizing by ring-opening cyclic ester compounds such as ε-caprolactone, γ-butyrolactone, 2-methylcaprolactone, 4-methylcaprolactone, β-propiolactone, δ-valerolactone and β-methyl-δ-valerolactone, using monooxycarboxylic acid or polyoxycarboxylic acid such as lactic acid, caproic acid, 12-hydroxystearic acid, dimethylolpropionic acid and dimethylolbutanoic acid as a initiator; polyester monool compounds containing a hydroxyl group, which are obtained by polymerizing by ring-opening the cyclic ester compounds, using a low molecular weight monool compound such as methanol or ethanol as an initiator; and polyester diol compounds containing a hydroxyl group, which are obtained by polymerizing by ring-opening the cyclic ester compounds, using a low molecular weight diol compound such as ethylene glycol or propylene glycol as an initiator).

Examples of the polyester compound include
(2) self-polycondensate of hydroxycarboxylic acid (for example, polyester compounds containing a carboxyl group and a hydroxyl group, which are obtained by polycondensating monooxycarboxylic acid such as lactic acid, caproic acid and 12-hydroxystearic acid).
Other examples of the polyester compound include (3) compounds obtained by polycondensating a low molecular weight diol compound and a low molecular weight dicarboxylic acid compound (for example, polyester diol compounds containing a hydroxyl group, which are obtained by reacting a low molecular weight diol compound component such as straight-chain glycols like ethylene glycol, 1,3-propanediol, 1,4-butanediol or 1,6-hexanediol; or branched glycols like 1,2-propanediol, neopentyl glycol, 3-methyl-1,5-pentanediol or ethylbutylpropanediol with a low molecular weight dicarboxylic acid compound component such as saturated or unsaturated aliphatic dicarboxylic acids like succinic acid, adipic acid, azelaic acid, sebacic acid or maleic acid; or aromatic dicarboxylic acids like phthalic acid in the presence of an excessive low molecular weight diol compound).

Furthermore Examples of the polyester compound include
(4) phosphate compounds of a ring-opening polymer of a cyclic ester compound using monoalcohol as an initiator (for example, polyester diol compounds containing a phosphoric acid group, which are obtained by esterifying the polyester monool compounds with phosphoric acid), and
(5) ring-opening polymerization compounds of a cyclic ester compound using an amino group-containing sulfonic acid compound as an initiator (for example, polyester diol compounds containing a sulfonic acid group, which are obtained by ring-opening polymerization of the cyclic ester compounds, using an amino group-containing sulfonic acid compound such as taurine as an initiator).
Furthermore Examples of the polyester compound include (6) sulfur dioxide adduct of a ring-opening polymer of a cyclic ester compound using monoalcohol as an initiator (for example, polyester diol compounds containing sulfonic acid group, which are obtained by adding sulfur dioxide gas to the polyester monool compounds).
As the polyester compound, a self polycondensate of hydroxycarboxylic acid is preferable, and a self polycondensate of 12-hydroxystearic acid is more preferable.

In addition, the polyester side chain-containing carbodiimide type compound is preferably one in which a number average molecular weight of the polyester side chain is 200 to 10000. The number average molecular weight of the present invention is provided based on a gel permeation chromatography (GPC) method <polystyrene equivalent basis>, and Water 2690 (manufactured by Nihon Waters K.K.) is used as a measuring apparatus and PLgel 5 µ MIXED-D (produced by Polymer Laboratories) is used as a column.

### 1-3) Material for introducing a basic nitrogen-containing group

The polyester side chain-containing carbodiimide type compound preferably further has a basic nitrogen-containing group.
The above-mentioned "basic nitrogen-containing group" includes a group containing nitrogen to act as a Lewis base as well as a group containing nitrogen to form a quaternary ammonium ion in water, and a typical group thereof is an amino group and a basic nitrogen-containing heterocyclic group. Examples of the amino group include a tertiary amino group. As the basic nitrogen-containing group, the tertiary amino group is preferred.
Examples of a method of obtaining a carbodiimide type compound having such a basic nitrogen-containing group include a method of reacting the carbodiimide group with a compound having a functional group capable of reacting with the carbodiimide group and a basic nitrogen-containing group to introduce the basic nitrogen-containing group into the side chain, and a method of reacting the isocyanate group with a compound having a functional group capable of reacting with the isocyanate group and a basic nitrogen-containing group to introduce the basic nitrogen-containing group into the main chain in the case where the carbodiimide compound has an isocyanate group.
Examples of the functional group to react with the carbodiimide group include the functional groups described above for the polyester compound, and examples of the functional group to react with the isocyanate group include a hydroxyl group and an amino group.

The method of introducing the basic nitrogen-containing group into the main chain of the carbodiimide type compound by use of the reaction with the isocyanate group is one of suitable methods. When the basic nitrogen-containing group is introduced into the carbodiimide type compound, it is preferred to use a compound having a hydroxyl group which is suitable as a functional group capable of reacting selectively with the isocyanate group, and a tertiary amino group or a basic nitrogen-containing heterocyclic group which does not concern the reaction with the carbodiimide group or the isocyanate group.
Specific examples of compounds having a hydroxyl group and a tertiary amino group include N,N-dialkylalkanolamine compounds such as N,N-dimethylethanolamine and N,N-diethylethanolamine; ethylene oxide addition products of secondary amine compounds; and reaction products of secondary amine compounds and an epoxy compound.
Examples of compounds having two hydroxyl groups and a tertiary amino group include N-alkyldialkanolamine compounds such as N-methyldiethanolamine and N-ethyldiethanolamine; ethylene oxide addition products of primary amine compounds; and reaction products of primary amine compounds and an epoxy compound.
Further, as the compound having a hydroxyl group and a basic nitrogen-containing heterocyclic group, for example, compounds having a heterocycle containing tertiary basic nitrogen and a hydroxyl group, such as hydroxypyridine, pyridinemethanol, pyridineethanol, pyridine, pyrazine, triazine or quinoline, can be used. Even a heterocyclic compound containing secondary basic nitrogen such as piperidine or piperazine can be used by alkylating it to convert to a tertiary compound to contain a hydroxyl group.

The basic nitrogen-containing group may be introduced into the end of the main chain by reacting 2 moles of a compound having a hydroxyl group with 1 mole of the carbodiimide compound expressed by the above-mentioned formula (1), or the basic nitrogen-containing group may be introduced into the main chain by reacting a compound having two hydroxyl groups with the carbodiimide compound expressed by the above-mentioned formula (1) in such an amount that the isocyanate group is more than the hydroxyl group, and such a compound in which the basic nitrogen-containing group is introduced into the main chain thereof is a more preferable compound.

Further, in the reactions described above, that is, the ring-opening reaction of a cyclic ester compound using the hydroxyl group-containing compound as an initiator, the polycondensation reaction of oxycarboxylic acid, the polycondensation reaction between a low molecular weight diol compound and a low molecular weight dicarboxylic acid compound, the reaction between the carbodiimide group and a carboxyl group, a sulfonic acid group, a phosphoric acid group, a hydroxyl group or an amino group, and the reaction between the isocyanate group and a hydroxyl group or an amino group, normal methods can be used.

### 2) Molecular structure and effect of carbodiimide type compound

The carbodiimide type compound is prepared by using the above-mentioned materials, and materials to be introduced as the polyester side chain are introduced into the carbodiimide compound, a starting material, through the reaction with the carbodiimide group.
Such the carbodiimide type compound, for example, when a compound having a structure of the formula (1) is used as a carbodiimide compound of a starting material, can be schematically expressed in the form of the following formula (4):

OCN-X₍₁₎-(N=C=N)₍ₙ₋₁₎-OCN (4)

wherein X independently denotes a constituent unit containing a polyester chain bonded through a linking group formed by reaction of a carbodiimide group with a functional group reactive therewith; 1 denotes the number of the constituent units X in one molecule and an integer of one or higher; n denotes the number of carbodiimide groups in the carbodiimide compound as a starting material and an integer of one or higher; and (n - l) denotes an integer of 0 or higher. A is omitted in this formula.

Further, as for the introduction of the basic nitrogen-containing group used arbitrarily, a method of introducing the basic nitrogen-containing group through either of a reaction with the carbodiimide group or a reaction with the isocyanate group can be employed. Such the carbodiimide type compound, for example, when a compound having a structure of the formula (1) is used as a carbodiimide compound of a starting material, can be schematically expressed in the form of the following formula (5):

Y-X₍₁₎-Z₍ₘ₎- (N=C=N)₍ₙ₋₁ₘ₎-Y (5)

wherein X, n and l can be respectively defined as described above; Y independently denotes a non-reacted isocyanate group or a constitutional unit containing a basic nitrogen-containing group bonded through a linking group formed by reaction of an isocyanate group with a functional group reactive therewith; Z independently denotes a constitutional unit containing a basic nitrogen-containing group bonded through a linking group formed by reaction of a carbodiimide group and a functional group reactive therewith; m denotes the number of the constituent units Z in the molecule and is an integer of 0 or higher; and (n - l - m) also denotes an integer of 0 or higher. A is omitted in this formula.

The above-mentioned formulas (4) and (5) symbolically show only main portions and although the structures formed by respectively continuing the constituent units of X and Z are typically defined, structures in which X, Z, and - (N=C=N) - are bonded randomly are also included. The formula (4) shows the basic configuration of the carbodiimide type compound of the present invention and on the other hand, the formula (5) shows a preferable configuration for multi-functionalization.

Further, the portion defined by Y in the above-mentioned formula (5) is other than a basic nitrogen-containing group and may be a constituent unit bonded through a linking group by similar reaction of a compound possible to be reacted with the isocyanate group. The compound having a functional group reactive with the isocyanate group is preferably those which have low reactivity with the carbodiimide group but is selectively reactive with the isocyanate group in higher priority and examples thereof include low molecular weight monoalcohol compounds such as methanol and ethanol.

The linking group formed at the time of introducing the above-mentioned side chain by reaction of the functional group reactive with the carbodiimide group is generally formed by reaction of the carbodiimide group with a carboxyl group, a sulfonic acid group, a phosphoric acid group, a hydroxyl group, an amino group, and has the following structure.

For example, the linking group formed by reaction of the carbodiimide group and a carboxyl group is defined by the following formulas (6) and (7); the linking group formed by reaction of the carbodiimide group and a hydroxyl group is defined by the following formulas (8) and (9); the linking group formed by reaction of the carbodiimide group and an amino group is defined by the following formula (10); the linking group formed by reaction of the carbodiimide group and a sulfonic acid group is defined by the following formula (11) ; and the linking group formed by reaction of the carbodiimide group and a phosphoric acid group is defined by the following formula (12).

Further, the linking group formed by reaction of the functional group reactive with an isocyanate group is generally formed by reaction of the isocyanate group with a hydroxyl group, primary and secondary amino groups.
For example, the linking group formed by reaction of the isocyanate group and a hydroxyl group is defined by the following formula (13) and the linking group formed by reaction of the isocyanate group, and primary or secondary amino group is defined by the following formula (14).

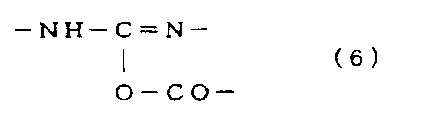

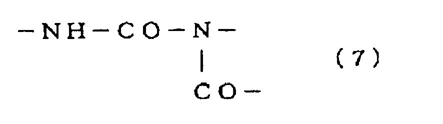

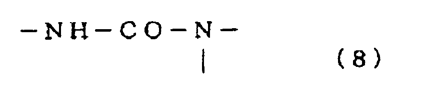

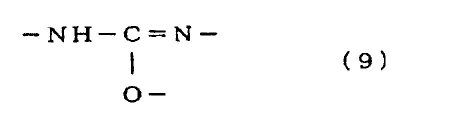

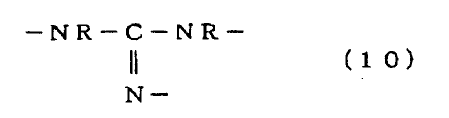

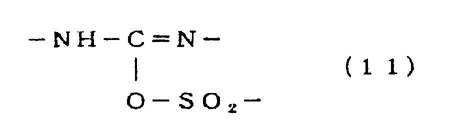

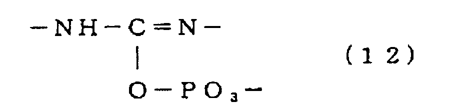

-O-CO-NH- (13)

-NR-CO-NH- (14)

In the above-mentioned formulas, R denotes a hydrogen atom or a hydrocarbon group with 1 or more carbon atoms.
As described above, the carbodiimide type compound of the present invention is a compound having a constituent unit denoted as X in the formula (4) and formed by introducing at least one polyester chain through at least one linking group defined by any one of the formulas (6) to (12) into the carbodiimide group portion of the carbodiimide compound defined by the formula (1), which is a starting material. Further, the carbodiimide type compound of the present invention is a compound having a constituent unit denoted as Z in the formula (5) and formed by introducing and a basic nitrogen-containing group or a functional side chain similarly, and a compound formed by introducing a basic nitrogen-containing group or a functional chain through a linking group defined by the formula (13) or (14) into both terminals or one terminal of the molecular. In particular, compounds having the carbodiimide group remaining in the molecule are preferable.

The carbodiimide type compound of the present invention has an excellent dispersibility of the toner particle by having a polyester side chain, and when it is used for the liquid developer, it is possible to achieve a balance between maintaining of an insulating property or an electrically charged characteristic and the dispersibility of the pigment or the toner particle

### 3) Method for producing carbodiimide type compound

When the carbodiimide type compound of the present invention is produced using the above-mentioned material, as all reactions, namely reactions for introducing the side chain such as the reaction between the carbodiimide group and a carboxyl group, the reaction between the isocyanate group and a hydroxyl group, normal methods can be employed. Furthermore, the order of introducing the polyester side chain or the basic nitrogen-containing group is not particularly limited, and for example when two or more species of compounds having the functional group to react with the carbodiimide group are used, these compounds can be added separately or can be added simultaneously to be reacted, and also when two or more species of compounds having the functional group to react with the isocyanate group are used, these compounds can be added separately or can be added simultaneously to be reacted. When a compound having the functional group to react with the carbodiimide group, and a compound having the functional group to react with the isocyanate group are used, the compound may be reacted with the carbodiimide group first, or may be reacted with the isocyanate group first if the same compounds are finally obtained.

In addition, it is preferred that species and ratios of the polyester side chain and the basic nitrogen-containing group, which are introduced into a molecule, and further number of remaining carbodiimide groups are appropriately determined according to species of a pigment or a dispersion medium, for example, in the case of being used as a liquid developer and performance required in other application areas to mix the respective materials so that the carbodiimide type compound finally becomes a compound having good balanced performance.

A number average molecular weight of the carbodiimide type compound of the present invention obtained from the materials and the methods of production described above is preferably 1000 or more, and 100000 or less. When the number average molecular weight is too large, a liquid developer having proper viscosity may not be obtained in making the liquid developer from the carbodiimide type compound and it is unfavorable particularly when a high concentration liquid developer is needed. On the other hand, when the number average molecular weight is too small, the dispersion stability of a pigment in the liquid developer may be deteriorated and this is not preferred. The number average molecular weight is more preferably is 1000 or more, and 50000 or less.

It is necessary that an adequate covalent bond and an adequate adsorption force act upon the dispersant so that the dispersant does not leave the surface of the pigment or the toner particle with time, and therefore it is preferred to adjust the carbodiimide equivalent weight and the amine value according to pigments or resins composing the toner particle to be used. Further, it is preferred that the polyester side chain itself is soluble in an insulating hydrocarbon organic solvent since thereby better dispersion stability of the pigment and toner particles can be maintained.

The polyester side chain-containing carbodiimide type compound is preferably a compound with a carbodiimide equivalent weight of 100 to 50000. Herein, the term carbodiimide equivalent weight refers to a number expressed by (a molecular weight of a carbodiimide type compound)/(number of carbodiimide groups in a carbodiimide type compound molecule). When the carbodiimide equivalent weight of the carbodiimide type compound is too high, a weight ratio of the polyester side chain to the whole molecule of the carbodiimide type compound deceases, and the dispersion stability of the pigment may be deteriorated. On the other hand, a compound having the small carbodiimide equivalent weight is favorable in that a weight ratio of the polyester side chain or a side chain having functionality to the whole molecule of the carbodiimide type compound can be enhanced, but the synthesis of the carbodiimide type compound itself and the control of a reaction for introducing a side chain may become difficult. A more preferable carbodiimide equivalent weight is at least 200 and at most 10000.

The polyester side chain-containing carbodiimide type compounds can be used singly or may be used in combination of two or more species of them in the liquid developer of the present invention.
The total amount of the dispersant to be used is preferably 0.1 to 200% by mass with respect to the amount of the pigment in the liquid developer, and more preferably 10 to 100% by mass.

The liquid developer of the present invention may further include a charge control agent as required in addition to these materials, and there are the charge control agents broadly divided into two types (1) and (2) described below.
(1) Type in which the surface of the toner particle is ionized or coated with a substance which can perform the adsorption of ion. As this type, fats such as linseed oil, soybean oil; and an alkyd resin, a halogenated polymer, aromatic polycarboxylic acid, an acid group-containing water-soluble dye, and oxidative condensation products of aromatic polyamine are suitable.
(2) Type in which substances which is dissolved in an insulating hydrocarbon organic solvent and can exchange ions with the toner particle coexist, and metal soaps such as cobalt naphthenate, nickel naphthenate, iron naphthenate, zinc naphthenate, cobalt octylate, nickel octylate, zinc octylate, cobalt dodecylate, nickel dodecylate, zinc dodecylate and cobalt 2-ethylhexanoate; sulfonic acid metal salts such as petroleum sulfonic acid metal salt and metal salt of sulfosuccinate; phosphatide such as lecitin; salicylic acid metal salts such as t-butylsalicylic acid metal complex; a polyvinylpyrrolidone resin, a polyamide resin, a sulfonic acid-containing resin, and a hydroxybenzoic acid derivative are suitable.
Further, other additives can be mixed as required.

Next, a method for producing the liquid developer of the present invention will be described.
First, the pigment and the resin are heated and kneaded with a three roll mill, a biaxial extruder, and after extruded mixture was quenched, the obtained colored chips were dry ground with a grinder such as a hammer mill, a jet mill, apinmill, a turbo mill, a cutter mill, or a ball mill . Further, the polyester side chain-containing carbodiimide type compound of the present invention is added to a ground substance obtained by dry grinding. The liquid developer of the present invention can be obtained by wet grinding the resulting mixture in an insulating hydrocarbon solvent with a wet-grinder such as a media type dispersing machine, for example, an Attritor, a sand mill, a Dyno-Mill, a ball mill, a DCP mill, an apex mill, a pearl mill, or a media-less dispersing machine, for example, Altymizer (manufactured by SUGINO MACHINE Ltd.), Nanomizer (manufactured by NANOMIZER Inc.), a Microfluidizer (manufactured by MIZUHO Industrial Co., Ltd.), DeBee 2000 (manufactured by DeBee International Inc.). Further, the charge control agent which can be added to the liquid developer as required can be added during wet grinding and/or after wet grinding.

Since the liquid developer of the present invention minimizes the adverse effect on electric resistance and the electrically charged characteristics of toner particles and is superior in the dispersibility of a pigment and the dispersion stability of the toner particles, it can be used as a liquid developer for electrophotography or electrostatic recording used in printing machines, copiers, printers and facsimiles.

By using the dispersant of the present invention, a liquid developer can be applied to all liquid developers using pigments. In addition, the liquid developer, in which the adverse effect on electric resistance of the liquid developer and the electrically charged characteristics of toner particles is minimized and the dispersibility of a pigment and the dispersion stability of the toner particles are improved, is obtained.

### BEST MODE FOR CARRYING OUT THE INVENTION

Hereinafter, the liquid developer of the present invention will be described in more detail by way of examples. In addition, "part (s)" and "%" refer to "part(s) by mass" and "% by mass" in the following descriptions, unless otherwise specified.

### (Synthesis Example 1)

### <Dispersant 1> (without a basic nitrogen-containing group)

Into a four necked flask equipped with a reflux condenser tube, a nitrogen inlet tube, a stirring rod and a thermometer, 132.4 parts of a toluene solution (solid content 50%) of a polycarbodiimide compound with a carbodiimide equivalent weight of 316 having an isocyanate group and 17.0 parts of 2,4-diethyl-1,5-pentanediol were charged, and the resulting mixture was maintained at about 100°C for 3 hours to react a isocyanate group with a hydroxyl group. Then, 169.7 parts of self-polycondensate of 12-hydroxystearic acid having a number average molecular weight of 1600, which has a carboxyl group at the end was charged, and the resulting mixture was maintained at about 80°C for 2 hours to react a carbodiimide group with the carboxyl group, and then toluene was distilled off under a reduced pressure to obtain a pigment dispersant 1 (solid content 100%) with a carbodiimide equivalent weight of 2400 having a number average molecular weight of about 9500.

### (Synthesis Example 2)

### <Dispersant 2> (with a basic nitrogen-containing group)

Into a four necked flask equipped with a reflux condenser tube, a nitrogen inlet tube, a stirring rod and a thermometer, 132.6 parts of a toluene solution (solid content 50%) of a polycarbodiimide compound with a carbodiimide equivalent weight of 316 having an isocyanate group and 12.8 parts of N-methyldiethanolamine were charged, and the resulting mixture was maintained at about 100°C for 3 hours to react a isocyanate group with a hydroxyl group. Then, 169.3 parts of self-polycondensate of 12-hydroxystearic acid having a number average molecular weight of 1600, which has a carboxyl group at the end was charged, and the resulting mixture was maintained at about 80°C for two hours to react a carbodiimide group with the carboxyl group, and then toluene was distilled off under a reduced pressure to obtain a pigment dispersant 2 (solid content 100%) with a carbodiimide equivalent weight of 2400 having a number average molecular weight of about 9300, and an amine value of 23.5.

### <Comparative pigment dispersant>

As a comparative pigment dispersant, SOLSPERS 17000 (produced by Avecia Inkjet Ltd.) was used.

### <Resin 1>

As a thermoplastic resin, an epoxy resin (AER6064 produced by Asahi Kasei Corporation) was used.

### <Resin 2>

76.7 parts of styrene (St), 14.7 parts of stearyl methacrylate (SMA), 8.6 parts of dimethylacrylamide (DMAA), 160 parts of toluene and 1.5 parts of azobis(isobutyronitrile) as an initiator were mixed, and the resulting mixture was radically polymerized at 80°C for 10 hours. By heating the obtained resin solution at 150°C under a reduced pressure of 70 cmHg (≈ 93 kPa) for 8 hours, toluene, unreacted monomers and low molecular weight oligomer were distilled off to obtain resin 2. The obtained resin 2 had composition (St:SMA:DMAA = 85:5:10 by mole), a weight average molecular weight of 45800 and a melting point of 92°C.

### (Example 1)

250 parts by mass of pigment blue 15:3 and 750 parts by mass of the resin 1 were melted and kneaded at 140°C using a hot three roll, and the resulting kneaded substance was cooled and powdered. Then, 140 parts by mass of the powdered substance, 8.8 parts by mass of the dispersant 1 and 551.2 parts by mass of liquid paraffin (MORESCO WHITE P-40 produced by MATSUMURA OIL RESEARCH Corp.) were wet ground at 40°C for about 90 minutes with EIGER mill (trade name: M-250) filled with zirconia beads with 0.5 mm in diameter to obtain a liquid developer 1 having the solid content of 20% by mass.

### (Example 2)

A liquid developer 2 was obtained by following the same method as in Example 1 except for using the dispersant 2 as a dispersant and the resin 2 in place of the resin 1.

### (Example 3)

333 parts by mass of pigment blue 15:3 and 667 parts by mass of an epoxy resin (AER6064 produced by Asahi Kasei Corp.) were melted and kneaded at 140°C using a hot three roll, and the resulting kneaded substance was cooled and powdered. Then, 210 parts by mass of the powdered substance, 8.8 parts by mass of the dispersant 1 and 481.2 parts by mass of liquid paraffin (MORESCO WHITE P-40 produced by MATSUMURA OIL RESEARCH Corp.) were wet ground at 40°C for about 90 minutes with EIGER mill (trade name: M-250) filled with zirconia beads with 0.5 mm in diameter to obtain a liquid developer 3 having the solid content of 30% by mass.

### (Comparative Example 1)

A liquid developer of Comparative Example 1 was obtained by following the same method as in Example 1 except for using SOLSPERS 17000 as a dispersant.

### (Comparative Example 2)

A liquid developer of Comparative Example 2 was obtained by following the same method as in Example 1 except for not using a dispersant.

### <Evaluation method>

Each liquid developer was evaluated according to the following evaluation methods, and the results of evaluations are shown in Table 1.

### (Viscosity)

Viscosity at 25°C of each of the liquid developers prepared in Examples 1 to 3 and Comparative Examples 1 and 2 was measured in terms of viscosity after 60 seconds with an E type viscometer (20 rpm for viscosity of 10 to 30 cps, 5 rpm for viscosity higher than 100 cps) manufactured by Toki Sangyo Co., Ltd. The results are shown in Table 1.

### (Volume resistivity)

On the liquid developers prepared in Examples 1 to 3 and Comparative Examples 1 to 2, the volume resistivity of the liquid developer was measured with R834 manufactured by ADVANCE Co., Ltd. The results are shown in Table 1.

### (Average particle diameter)

On the liquid developers prepared in Examples 1 to 3 and Comparative Examples 1 to 2, the average particle diameter of the toner particles was measured with an optical electron microscope (BH-2 manufactured by Olympus Corp.). The results are shown in Table 1.

| | Dispersant for use | Viscosity (cps) | Average particle diameter (µm) | Volume resistivity (Ω·cm) |
|---|---|---|---|---|
| Example 1 | Dispersant 1 | 32 | 1-2 | 6.00E+13 |
| Example2 | Dispersant 2 | 28 | 1-2 | 6.00E+13 |
| Example3 | Dispersant 1 | 50 | 1-2 | 6.00E+13 |
| Comparative Example 1 | SOLSPERS 17000 | 30 | 1-4 | 8.00E+12 |
| Comparative Example 2 | Without dispersant | -^{*1)} | >5 | 3.00E+14 |

| | | | | |
|---|---|---|---|---|
| *1) In Comparative Example 2, the viscosity was too high to be measured | | | | |

## Claims

1. A liquid developer, which is obtained by dispersing colored resin particles encapsulating a pigment in an insulating hydrocarbon organic solvent by a wet-grinding method using a dispersant,
wherein said dispersant is a polyester side chain-containing carbodiimide type compound formed by introducing a polyester side chain into a molecule of a carbodiimide compound through a reaction with a carbodiimide group.

2. The liquid developer according to claim 1,
wherein a polyester side chain-containing carbodiimide type compound with a carbodiimide equivalent weight of 100 to 50000 is used as said dispersant.

3. The liquid developer according to claim 1 or 2,
wherein a polyester side chain-containing carbodiimide type compound having a basic nitrogen-containing group is used as said dispersant.

4. The liquid developer according to claim 3,
wherein a polyester side chain-containing carbodiimide type compound having a basic nitrogen-containing group on the main chain of the carbodiimide type compound is use as said dispersant.

5. The liquid developer according to claim 3 or 4,
wherein said basic nitrogen-containing group is a tertiary amino group.

6. The liquid developer according to any one of claims 1 to 5,
wherein a polyester side chain-containing carbodiimide type compound in which a number average molecular weight of the polyester side chain is 200 to 10000 is used as said dispersant.

7. The liquid developer according to any one of claims 1 to 6,
wherein a polyester side chain-containing carbodiimide type compound into which a polyester side chain resulting from self polycondensate of hydroxycarboxylic acid is introduced is used as said dispersant.

8. The liquid developer according to any one of claims 1 to 7,
wherein a polyester side chain-containing carbodiimide type compound into which a polyester side chain resulting from self polycondensate of 12-hydroxystearic acid is introduced is used as said dispersant.

9. The liquid developer according to any one of claims 1 to 8,
wherein a paraffinic solvent having a high boiling point is used as said insulating hydrocarbon organic solvent.

## Patentansprüche

1. Flüssiger Entwickler, der durch Dispergieren gefärbter Harzpartikel, die ein Pigment einkapseln, in einem isolierenden organischen Kohlenwasserstofflösungsmittel mittels eines Naß-Schleif-Verfahren unter Verwendung eines Dispersionsmittels erhalten wird,
wobei das Dispersionsmittel eine Polyester-Seitenkette enthaltende Carbodiimid-Verbindungsart ist, die durch Einführen einer Polyester-Seitenkette in ein Molekül einer Carbodiimid-Verbindung durch eine Reaktion mit einer Carbodiimide-Gruppe gebildet ist.

2. Flüssiger Entwickler nach Anspruch 1,
wobei eine Polyester-Seitenkette enthaltende Carbodiimid-Verbindungsart mit einem Carbodiimid-Äquivalentgewicht von 100 bis 50.000 als Dispersionsmittel verwendet wird.

3. Flüssiger Entwickler nach Anspruch 1 oder 2,
wobei eine Polyester-Seitenkette enthaltende Carbodiimid-Verbindungsart, welche eine basischen Stickstoff enthaltende Gruppe aufweist, als Dispersionsmittel verwendet wird.

4. Flüssiger Entwickler nach Anspruch 3,
wobei eine Polyester-Seitenkette enthaltende Carbodiimid-Verbindungsart, welche eine basischen Stickstoff enthaltende Gruppe an der Hauptkette der Carbodiimid-Verbindungsart aufweist, als Dispersionsmittel verwendet wird.

5. Flüssiger Entwickler nach Anspruch 3 oder 4
wobei die basischen Stickstoff enthaltende Gruppe eine tertiäre Aminogruppe ist.

6. Flüssiger Entwickler nach einem der Ansprüche 1 bis 5,
wobei eine Polyester-Seitenkette enthaltende Carbodiimid-Verbindungsart, in welcher ein durchschnittliches Molekulargewicht der Polyester-Seitenkette 200 bis 10.000 beträgt, als Dispersionsmittel verwendet wird.

7. Flüssiger Entwickler nach einem der Ansprüche 1 bis 6,
wobei eine Polyester-Seitenkette enthaltende Carbodiimid-Verbindungsart, in welche eine durch Selbstkondensation von Hydroxycarbonsäure entstandene Polyester-Seitenkette eingeführt ist, als Dispersionsmittel verwendet wird.

8. Flüssiger Entwickler nach einem der Ansprüche 1 bis 7,
wobei eine Polyester-Seitenkette enthaltende Carbodiimid-Verbindungsart, in welche eine durch Selbstkondensation von 12-Hydroxystearinsäure entstandene Polyester-Seitenkette eingeführt ist, als Dispersionsmittel verwendet wird.

9. Flüssiger Entwickler nach einem der Ansprüche 1 bis 8,
wobei ein Paraffinlösungsmittel mit einem hohen Siedepunkt als nichtleitendes organisches Kohlenwasserstofflösungsmittel verwendet wird.

## Revendications

1. Révélateur liquide, lequel est obtenu par dispersion de particules de résine colorée encapsulant un pigment dans un solvant organique hydrocarboné isolant par un procédé de broyage à l'état humide en utilisant un dispersant,
dans lequel ledit dispersant est un composé de type carbodiimide contenant une chaîne latérale de polyester formé en introduisant une chaîne latérale de polyester dans une molécule d'un composé carbodiimide par une réaction avec un groupe carbodiimide.

2. Révélateur liquide selon la revendication 1, dans lequel un composé de type carbodiimide contenant une chaîne latérale de polyester avec une masse équivalente de carbodiimide de 100 à 50 000 est utilisé comme ledit dispersant.

3. Révélateur liquide selon la revendication 1 ou 2, dans lequel un composé de type carbodiimide contenant une chaîne latérale de polyester présentant un groupe contenant de l'azote basique est utilisé comme ledit dispersant.

4. Révélateur liquide selon la revendication 3, dans lequel un composé de type carbodiimide contenant une chaîne latérale de polyester présentant un groupe contenant de l'azote basique sur la chaîne principale du composé de type carbodiimide est utilisé comme ledit dispersant.

5. Révélateur liquide selon la revendication 3 ou 4, dans lequel ledit groupe contenant de l'azote basique est un groupe amino tertiaire.

6. Révélateur liquide selon l'une quelconque des revendications 1 à 5, dans lequel un composé de type carbodiimide contenant une chaîne latérale de polyester dans laquelle une masse moléculaire moyenne en nombre de la chaîne latérale de polyester est de 200 à 10 000 est utilisé comme ledit dispersant.

7. Révélateur liquide selon l'une quelconque des revendications 1 à 6, dans lequel un composé de type carbodiimide contenant une chaîne latérale de polyester dans laquelle une chaîne latérale de polyester résultant d'un auto polycondensat d'acide hydroxycarboxylique est utilisé comme ledit dispersant.

8. Révélateur liquide selon l'une quelconque des revendications 1 à 7, dans lequel un composé de type carbodiimide contenant une chaîne latérale de polyester dans lequel est introduit une chaîne latérale de polyester résultant d'un auto-polycondensat d'acide 12-hydroxy-stéarique est utilisé comme ledit dispersant.

9. Révélateur liquide selon l'une quelconque des revendications 1 à 8, dans lequel un solvant paraffinique présentant un point d'ébullition élevé est utilisé comme ledit solvant organique hydrocarboné isolant.
